# EUROPÄISCHE PATENTSCHRIFT

(11) **EP 4 066 601 B1**
(45) Veröffentlichungstag und Bekanntmachung des Hinweises auf die Patenterteilung: **09.10.2024**
(21) Anmeldenummer: 20812285.3
(22) Anmeldetag: 24.11.2020
(51) Int. Cl.: H05K 5/00, H05K 9/00

(54) **ELEKTRISCHES GERÄT**
ELECTRIC DEVICE
DISPOSITIF ÉLECTRIQUE

(30) Priorität: 25.11.2019 DE 102019218210
(43) Veröffentlichungstag der Anmeldung: 05.10.2022
(73) Patentinhaber: Lenze Swiss AG, 8590 Romanshorn (CH)
(72) Erfinder: BEILFUSS-SPICKMANN, Uwe, 31840 Hessisch Oldendorf (DE); FÄSSLER, Benjamin, 9104 Waldstatt (CH); HOFFMANN, Ewgeni, 31855 Aerzen (DE); SCHNEGGENBURGER, Christof, 8594 Güttingen (CH)
(74) Vertreter: Patentanwälte Ruff, Wilhelm, Beier, Dauster & Partner mbB
(86) Internationale Anmeldenummer: PCT/EP2020/083220
(87) Internationale Veröffentlichungsnummer: WO 2021/105128

(56) Entgegenhaltungen:
- US-A1- 2012 119 757

## Beschreibung

Die Erfindung betrifft ein elektrisches Gerät.

Die US 2012/119757 A1 offenbart ein elektrisches Gerät nach dem Oberbegriff des Anspruchs 1 .

Der Erfindung liegt die Aufgabe zugrunde, ein elektrisches Gerät zur Verfügung zu stellen, das einfach und kostengünstig herstellbar ist.

Die Aufgabe wird durch die Merkmale nach Anspruch 1 gelöst.

Das elektrische Gerät weist ein Gehäuse mit einer ersten elektrisch leitfähigen Gehäusewand auf.

Das elektrische Gerät weist weiter eine erste Leiterplatte auf, die in dem Gehäuse angeordnet ist und die einen ersten elektrischen Leiter aufweist.

Die erste elektrisch leitfähige Gehäusewand ist mit dem ersten elektrischen Leiter der ersten Leiterplatte mittels einer Schraubverbindung reversibel elektrisch leitend verbindbar.

Gemäß einer Ausführungsform ist die erste Leiterplatte senkrecht zur ersten elektrisch leitfähigen Gehäusewand ausgerichtet.

Gemäß einer Ausführungsform ist an der ersten elektrisch leitfähigen Gehäusewand eine Halterung für die erste Leiterplatte angeordnet bzw. die erste elektrisch leitfähige Gehäusewand weist eine Halterung für die erste Leiterplatte auf. Die erste Leiterplatte kann in vorgesehener Einbaulage flächig auf der Halterung aufliegen.

Gemäß einer Ausführungsform verbindet die Schraubverbindung die erste Leiterplatte mit der Halterung lösbar mechanisch.

Gemäß einer Ausführungsform ist die Halterung elektrisch leitfähig mit der ersten elektrisch leitfähigen Gehäusewand verbunden.

Gemäß einer Ausführungsform sind die erste Gehäusewand und die Halterung einstückig ausgebildet.

Gemäß einer Ausführungsform sind die erste elektrisch leitfähige Gehäusewand und die Halterung als Stanz-Biege-Teil ausgebildet. Insbesondere wird die elektrisch leitfähige Gehäusewand im vorgegebenen Bereich der Halterung in einem ersten Bearbeitungsschritt U-förmig gestanzt, wobei nach dem Stanzen die Halterung nach innen gebogen wird, d.h. die Halterung ist dann ins Innere des Gehäuses gebogen und steht dann bevorzugt senkrecht auf der elektrisch leitfähigen Gehäusewand. Alternativ kann die Halterung auch mittels einer Löt- bzw. Schweißverbindung mit der ersten elektrisch leitfähigen Gehäusewand verbunden sein.

Gemäß einer Ausführungsform weist das elektrische Gerät einen Durchgriffsschutz auf, der eine Öffnung in der ersten elektrisch leitfähigen Gehäusewand, die durch die ins Innere des Gehäuses gebogen Halterung gebildet ist, verschließt, insbesondere um ein vorgegebene Schutzart zu erreichen, beispielsweise IP 20 oder IP 31. Eine benachbart und senkrecht zur ersten Gehäusewand angeordnete zweite Gehäusewand, insbesondere ein Deckel, kann den Durchgriffsschutz aufweisen.

Gemäß einer Ausführungsform weist eine Schraube der Schraubverbindung eine Längserstreckung auf, die senkrecht zur ersten Leiterplatte verläuft.

Gemäß einer Ausführungsform weist das elektrische Gerät eine zweite Leiterplatte auf, die planparallel zur ersten elektrisch leitfähigen Gehäusewand verläuft, wobei die zweite Leiterplatte die erste Leiterplatte zusätzlich zu der Halterung der ersten elektrisch leitfähigen Gehäusewand hält. Die zweite Leiterplatte kann mit einem vorgegebenen Abstand planparallel zur ersten elektrisch leitfähigen Gehäusewand verlaufen, wobei die erste Leiterplatte an einer Seite von der Halterung der ersten elektrisch leitfähigen Gehäusewand mechanisch fixiert ist und an einer anderen Seite von der zweiten Leiterplatte mechanisch fixiert ist.

Die erste Leiterplatte weist einen zweiten elektrischen Leiter auf. Das elektrische Gerät weist weiter herkömmliche Funk-Entstör-Komponenten auf, beispielsweise Funk-Entstör-Kondensatoren, Funk-Entstör-Drosseln, usw. Die Funk-Entstör-Komponenten sind auf der ersten Leiterplatte angeordnet und mit dem zweiten elektrischen Leiter elektrisch verbunden. Der zweite elektrische Leiter ist/wird mittels der Schraubverbindung bzw. bei vorhandener Schraubverbindung mit dem ersten elektrischen Leiter elektrisch verbunden. Entsprechend ist/wird der zweite elektrische Leiter von dem ersten elektrischen Leiter elektrisch getrennt, wenn die Schraubverbindung entfernt bzw. gelöst wird.

Das elektrische Gerät weist einen TT (Terre Terre)-Netz-Modus oder einen TN (Terre Neutre)-Netz-Modus auf, so lange die erste elektrisch leitfähige Gehäusewand mit dem ersten elektrischen Leiter der ersten Leiterplatte mittels der Schraubverbindung elektrisch leitend verbunden ist. So lange die erste elektrisch leitfähige Gehäusewand nicht mit dem ersten elektrischen Leiter der ersten Leiterplatte mittels der Schraubverbindung elektrisch leitend verbunden ist, weist das elektrische Gerät einen IT(Isolé Terre)-Netz-Modus auf.

Das elektrische Gerät kann beispielsweise ein Stromrichter sein, insbesondere in Form eines Frequenzumrichters oder einer Netzrückspeiseeinheit. Eine Netzrückspeiseeinheit speist elektrische Energie/Leistung, die beispielsweise in einem Zwischenkreis vorhanden ist, in ein Versorgungsnetz zurück. Im Übrigen sei auch auf die einschlägige Fachliteratur verwiesen.

Die Erfindung wird nachfolgend unter Bezugnahme auf die Zeichnungen detailliert beschrieben. Hierbei zeigt:
- Fig. 1: eine perspektivische Ansicht eines elektrischen Geräts,
- Fig. 2: eine perspektivische Ansicht des elektrischen Geräts von Fig. 1 in teilweise geöffnetem Zustand,
- Fig. 3: eine perspektivische Ansicht auf eine Gehäusewand des elektrischen Geräts von Fig. 1 mit einer Halterung, die ins Innere eines Gehäuses gebogen ist, und
- Fig. 4: eine perspektivische Ansicht in ein Gehäuseinneres des elektrischen Geräts von Fig. 1.

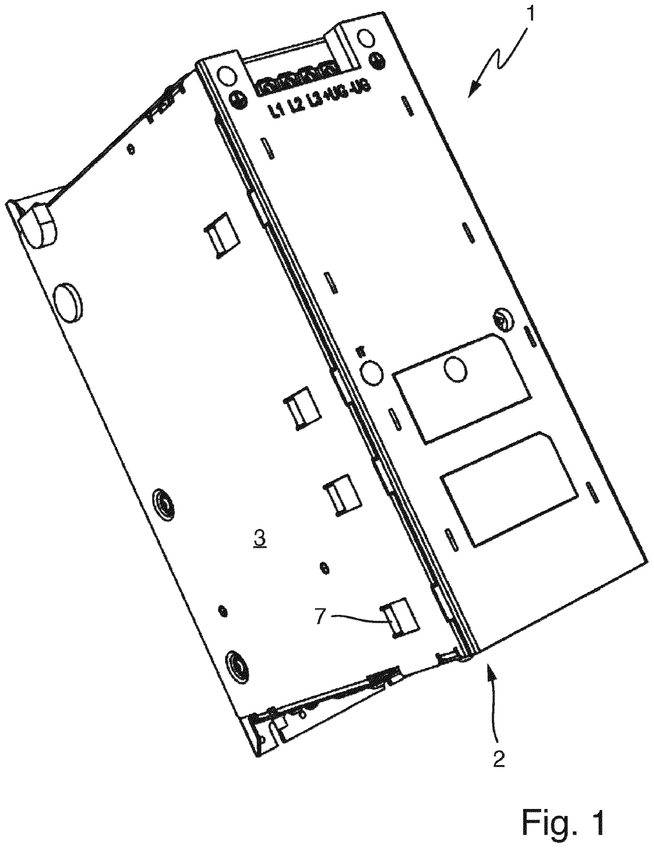

Fig. 1 zeigt eine perspektivische Ansicht eines elektrischen Geräts 1, beispielsweise in Form eines Frequenzumrichters.

Das elektrische Gerät 1 weist ein Gehäuse 2 mit einer ersten elektrisch leitfähigen Gehäusewand 3 und weiteren, nicht näher bezeichneten Gehäusewänden auf, die zusammen das Gehäuse 2 des elektrischen Geräts 1 bilden.

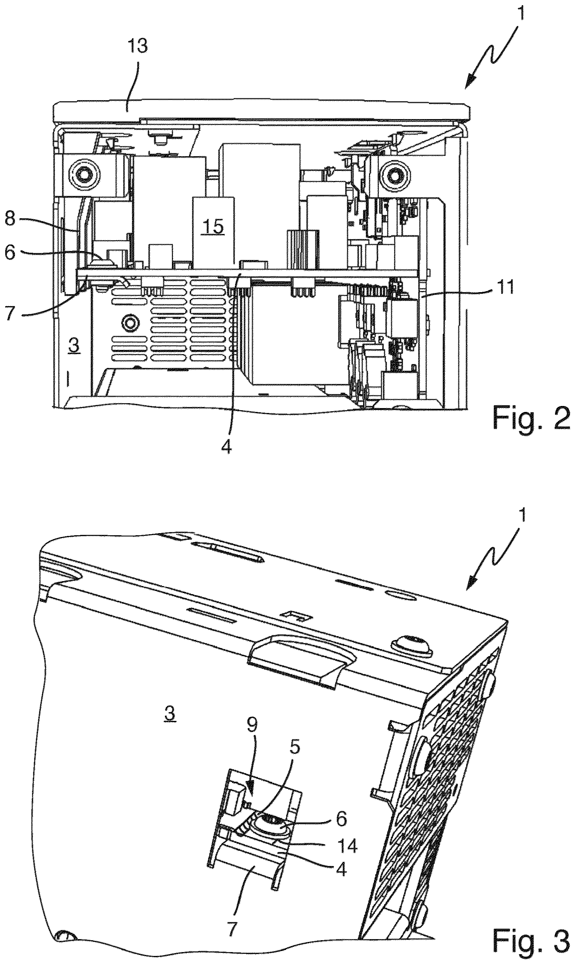

Bezug nehmend auf die Figuren 2 bis 4 weist das elektrische Gerät 1 eine erste Leiterplatte 4 mit einer Vielzahl von darauf angeordneten Bauelementen auf, wobei die erste Leiterplatte 4 in dem Gehäuse 2 angeordnet ist.

Die erste Leiterplatte 4 weist einen ersten elektrischen Leiter 5 in Form einer Leiterbahn auf, siehe Fig. 3. Selbstverständlich weist die erste Leiterplatte 4 neben dem ersten elektrischen Leiter 5 noch eine Vielzahl von weiteren elektrischen Leitern/Leiterbahnen auf, die jedoch aus Gründen der besseren Darstellbarkeit der erfindungswesentlichen Merkmale nicht gezeigt sind.

Bezug nehmend auf Fig. 3, die das elektrische Gerät 1 aus einer anderen Perspektive zeigt, ist die erste elektrisch leitfähige Gehäusewand 3 mit dem ersten elektrischen Leiter 5 der ersten Leiterplatte 4 mittels einer entfernbaren Schraubverbindung 6 elektrisch leitend verbunden.

Die erste Platine 4 ist senkrecht zur ersten elektrisch leitfähigen Gehäusewand 3 ausgerichtet.

An der ersten elektrisch leitfähigen Gehäusewand 3 ist eine Halterung 7 für die erste Platine 4 ausgebildet, wobei die erste Gehäusewand 3 und die Halterung 7 einstückig als Stanz-Biege-Teil verkörpert sind. Die Halterung 7 ist ins Innere des Gehäuses 2 gebogen.

Die Schraubverbindung 6 verbindet die erste Platine 4 mit der Halterung 7 lösbar mechanisch.

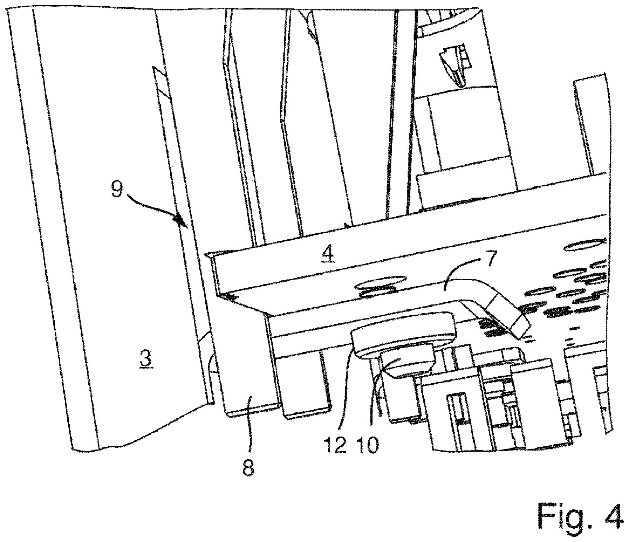

Die Schraubverbindung 6 ist mittels einer Schraube 10, siehe insbesondere Fig. 4, und einer in die Halterung 7 eingepressten Mutter 12 gebildet, wobei die Schraube 10 durch eine zugehörige Öffnung der Leiterplatte 4 hindurch, dann durch eine zugehörige Öffnung der Halterung 7 hindurch in die Mutter 12 eingreift. Es versteht sich, dass ein Schraubenkopf der Schraube 10 einen Durchmesser aufweist, der größer ist als die Öffnung der Leiterplatte. Die Schraube 10 weist in ihrem eingeschraubten Zustand eine Längserstreckung auf, die senkrecht zur ersten Leiterplatte 4 verläuft.

Bezug nehmend auf Fig. 4, weist das elektrische Gerät 1 einen Durchgriffsschutz 8 auf, der eine Öffnung 9 in der ersten elektrisch leitfähigen Gehäusewand 3, die durch die ins Innere des Gehäuses 2 gebogen Halterung 7 gebildet ist, verschließt. Der Durchgriffsschutz 8 kann Bestandteil eines Deckels 13 sein, siehe Fig. 2

Bezug nehmend auf Fig. 2, weist das elektrische Gerät 1 eine zweite Platine 11 auf, die planparallel, gegenüberliegend zur ersten elektrisch leitfähigen Gehäusewand 3 verläuft, wobei die zweite Platine 11 die erste Platine 4 hält bzw. stützt.

Wenn die erste elektrisch leitfähige Gehäusewand 3 mit dem ersten elektrischen Leiter 5 der ersten Platine 4 mittels der Schraubverbindung 6 elektrisch leitend verbunden ist, weist das elektrische Gerät 1 einen TT-Netz-Modus oder einen TN-Netz-Modus auf.

Wenn die erste elektrisch leitfähige Gehäusewand 3 nicht mit dem ersten elektrischen Leiter 5 der ersten Platine 4 mittels der Schraubverbindung 6 elektrisch leitend verbunden ist, d.h. wenn die Schraube 10 nicht eingedreht ist, weist das elektrische Gerät 1 einen IT-Netz-Modus auf.

Ein Eindrehen der Schraube 12 kann auf der ersten Leiterplatte 4 verschiedene Bereiche miteinander elektrisch verbinden, die bei nicht eingedrehter Schraube 12 voneinander elektrisch isoliert sind. Dies kann beispielsweise dazu verwendet werden, die beschriebenen Modi mit einzustellen. Insbesondere können Funkentstör-Komponenten durch Entfernen der Schraube 12 deaktiviert werden bzw. durch Eindrehen der Schraube 12 aktiviert werden.

Hierzu weist die erste Leiterplatte 4 einen zweiten elektrischen Leiter 14 auf. Das elektrische Gerät 1 weist weiter Funk-Entstör-Komponenten 15 auf, die auf der ersten Leiterplatte 4 angeordnet sind und die mit dem zweiten elektrischen Leiter 14 elektrisch verbunden sind. Der zweite elektrische Leiter 14 wird mittels der Schraubverbindung mit dem ersten elektrischen Leiter 5 elektrisch verbunden, so dass die Funk-Entstör-Komponenten 15 für diesen Fall aktiviert werden. Durch Lösen der Schraubverbindung werden die Funk-Entstör-Komponenten 15 deaktiviert.

Der zweite elektrische Leiter 14 kann beispielsweise mittels der Schraubverbindung mit dem ersten elektrischen Leiter 5 elektrisch dadurch verbunden werden, dass ein elektrisch leitender Schraubenkopf in einem vollständig eingeschraubten Zustand gleichzeitig auf dem ersten elektrischen Leiter 5 und auf dem zweiten elektrischen Leiter 14 aufliegt.

In IT-Netzen sind die Funk-Entstör-Komponenten 15 typisch deaktiviert, d.h. es ist keine Schraubverbindung vorhanden.

An der ersten Gehäusewand 3 können weitere Halterungen vorgesehen sein, die mechanisch wie die erste Halterung ausgeführt sind und die dieselbe Haltefunktion erfüllen, die jedoch keine Netzauswahlfunktion (IT, TN, usw.) ermöglichen.

## Patentansprüche

1. Elektrisches Gerät (1), aufweisend:
- ein Gehäuse (2) mit einer ersten elektrisch leitfähigen Gehäusewand (3) und
- eine erste Leiterplatte (4), die in dem Gehäuse (2) angeordnet ist und die einen ersten elektrischen Leiter (5) aufweist,
- wobei die erste elektrisch leitfähige Gehäusewand (3) mit dem ersten elektrischen Leiter (5) der ersten Leiterplatte (4) mittels einer Schraubverbindung (6) elektrisch leitend verbindbar ist,
**dadurch gekennzeichnet, dass**
- die erste Leiterplatte (4) einen zweiten elektrischen Leiter (14) aufweist,
- das elektrische Gerät (1) weiter Funk-Entstör-Komponenten (15) aufweist, die auf der ersten Leiterplatte (4) angeordnet sind und die mit dem zweiten elektrischen Leiter (14) elektrisch leitend verbunden sind,
- der zweite elektrische Leiter (14) mittels der Schraubverbindung mit dem ersten elektrischen Leiter (5) elektrisch leitend verbindbar ist,
- das elektrische Gerät (1) einen TT (Terre Terre)-Netz-Modus oder einen TN (Terre Neutre)-Netz-Modus aufweist, wenn die erste elektrisch leitfähige Gehäusewand (3) mit dem elektrischen Leiter (5) der ersten Leiterplatte (4) mittels der Schraubverbindung (6) elektrisch leitend verbunden ist, und
- das elektrische Gerät (1) einen IT(Isolé Terre)-Netz-Modus aufweist, wenn die erste elektrisch leitfähige Gehäusewand (3) nicht mit dem ersten elektrischen Leiter (5) der ersten Leiterplatte (4) mittels der Schraubverbindung (6) elektrisch leitend verbunden ist.

2. Elektrisches Gerät (1) nach Anspruch 1, **dadurch gekennzeichnet, dass**
- die erste Leiterplatte (4) senkrecht zur ersten elektrisch leitfähigen Gehäusewand (3) ausgerichtet ist.

3. Elektrisches Gerät (1) nach Anspruch 1 oder 2, **dadurch gekennzeichnet, dass**
- an der ersten elektrisch leitfähigen Gehäusewand (3) eine Halterung (7) für die erste Leiterplatte (4) angeordnet ist.

4. Elektrisches Gerät (1) nach Anspruch 3, **dadurch gekennzeichnet, dass**
- die Schraubverbindung (6) die erste Leiterplatte (4) mit der Halterung (7) lösbar mechanisch verbindet.

5. Elektrisches Gerät (1) nach Anspruch 3 oder 4, **dadurch gekennzeichnet, dass**
- die Halterung (7) elektrisch leitfähig mit der ersten elektrisch leitfähigen Gehäusewand (3) verbunden ist.

6. Elektrisches Gerät (1) nach einem der Ansprüche 3 bis 5, **dadurch gekennzeichnet, dass**
- die erste Gehäusewand (3) und die Halterung (7) einstückig ausgebildet sind.

7. Elektrisches Gerät (1) nach Anspruch 6, **dadurch gekennzeichnet, dass**
- die erste elektrisch leitfähige Gehäusewand (3) und die Halterung (7) als Stanz-Biege-Teil ausgebildet sind.

8. Elektrisches Gerät (1) nach Anspruch 7, **dadurch gekennzeichnet, dass**
- die Halterung (7) ins Innere des Gehäuses (2) gebogen ist.

9. Elektrisches Gerät (1) nach Anspruch 8, **dadurch gekennzeichnet, dass**
- das elektrische Gerät einen Durchgriffsschutz (8) aufweist, der eine Öffnung (9) in der ersten elektrisch leitfähigen Gehäusewand (3), die durch die ins Innere des Gehäuses (2) gebogen Halterung (7) gebildet ist, verschließt.

10. Elektrisches Gerät (1) nach einem der vorhergehenden Ansprüche, **dadurch gekennzeichnet, dass**
- eine Schraube (10) der Schraubverbindung (6) eine Längserstreckung aufweist, die senkrecht zur ersten Leiterplatte (4) verläuft.

11. Elektrisches Gerät (1) nach einem der vorhergehenden Ansprüche, **dadurch gekennzeichnet, dass**
- das elektrische Gerät (1) eine zweite Leiterplatte (11) aufweist, die planparallel zur ersten elektrisch leitfähigen Gehäusewand (3) verläuft, wobei die zweite Leiterplatte (11) die erste Leiterplatte (4) hält.

## Claims

1. Electrical device (1), comprising:
- a housing (2) having a first electrically conductive housing wall (3) and
- a first printed circuit board (4), which is arranged in the housing (2) and which has a first electrical conductor (5),
- wherein the first electrically conductive housing wall (3) can be electrically conductively connected to the first electrical conductor (5) of the first printed circuit board (4) by means of a screw connection (6), **characterized in that**
- the first printed circuit board (4) comprises a second electrical conductor (14),
- the electrical device (1) further comprises radio interference suppression components (15), which are arranged on the first printed circuit board (4) and which are electrically conductively connected to the second electrical conductor (14),
- the second electrical conductor (14) can be electrically conductively connected to the first electrical conductor (5) by means of the screw connection,
- the electrical device (1) has a TT (Terre Terre) grid mode or a TN (Terre Neutre) grid mode when the first electrically conductive housing wall (3) is electrically conductively connected to the first electrical conductor (5) of the first printed circuit board (4) by means of the screw connection (6), and
- the electrical device (1) has an IT (Isolé Terre) grid mode when the first electrically conductive housing wall (3) is not electrically conductively connected to the first electrical conductor (5) of the first printed circuit board (4) by means of the screw connection (6).

2. Electrical device (1) according to Claim 1, **characterized in that**
- the first printed circuit board (4) is oriented perpendicularly to the first electrically conductive housing wall (3).

3. Electrical device (1) according to Claim 1 or 2, **characterized in that**
- a holder (7) for the first printed circuit board (4) is arranged on the first electrically conductive housing wall (3).

4. Electrical device (1) according to Claim 3, **characterized in that**
- the screw connection (6) connects the first printed circuit board (4) to the holder (7) in a mechanically detachable manner.

5. Electrical device (1) according to Claim 3 or 4, **characterized in that**
- the holder (7) is electrically conductively connected to the first electrically conductive housing wall (3).

6. Electrical device (1) according to one of Claims 3 to 5, **characterized in that**
- the first housing wall (3) and the holder (7) are formed in one piece.

7. Electrical device (1) according to Claim 6, **characterized in that**
- the first electrically conductive housing wall (3) and the holder (7) are formed as a stamped and bent part.

8. Electrical device (1) according to Claim 7, **characterized in that**
- the holder (7) is bent into the interior of the housing (2).

9. Electrical device (1) according to Claim 8, **characterized in that**
- the electrical device has a reach-through protection system (8), which closes an opening (9) in the first electrically conductive housing wall (3), which is formed by the holder (7) that is bent into the interior of the housing (2).

10. Electrical device (1) according to one of the preceding claims, **characterized in that**
- a bolt (10) of the screw connection (6) has a longitudinal extent that runs perpendicularly to the first printed circuit board (4).

11. Electrical device (1) according to one of the preceding claims, **characterized in that**
- the electrical device (1) comprises a second printed circuit board (11), which runs plane-parallel to the first electrically conductive housing wall (3), wherein the second printed circuit board (11) holds the first printed circuit board (4).

## Revendications

1. Appareil électrique (1), présentant :
- un boîtier (2) pourvu d'une première paroi de boîtier (3) électriquement conductrice, et
- une première carte de circuits imprimés (4) qui est disposée dans le boîtier (2) et qui présente un premier conducteur électrique (5),
- dans lequel la première paroi de boîtier (3) électriquement conductrice peut être reliée de manière électriquement conductrice au premier conducteur électrique (5) de la première carte de circuits imprimés (4) au moyen d'un raccord à vis (6),
**caractérisé en ce que**
- la première carte de circuits imprimés (4) présente un deuxième conducteur électrique (14),
- l'appareil électrique (1) présente en outre des composants antiparasites (15) qui sont disposés sur la première carte de circuits imprimés (4) et qui sont reliés de manière électriquement conductrice au deuxième conducteur électrique (14),
- le deuxième conducteur électrique (14) peut être relié de manière électriquement conductrice au premier conducteur électrique (5) au moyen du raccord à vis,
- l'appareil électrique (1) présente un mode réseau TT (terre-terre) ou un mode réseau TN (terre-neutre) lorsque la première paroi de boîtier (3) électriquement conductrice est reliée de manière électriquement conductrice au conducteur électrique (5) de la première carte de circuits imprimés (4) au moyen du raccord à vis (6), et
- l'appareil électrique (1) présente un mode réseau IT (isolé-terre) lorsque la première paroi de boîtier (3) électriquement conductrice n'est pas reliée de manière électriquement conductrice au conducteur électrique (5) de la première carte de circuits imprimés (4) au moyen du raccord à vis (6).

2. Appareil électrique (1) selon la revendication 1, **caractérisé en ce que**
- la première carte de circuits imprimés (4) est orientée perpendiculairement à la première paroi de boîtier (3) électriquement conductrice.

3. Appareil électrique (1) selon la revendication 1 ou 2, **caractérisé en ce que**
- un support (7) pour la première carte de circuits imprimés (4) est disposé sur la première paroi de boîtier (3) électriquement conductrice.

4. Appareil électrique (1) selon la revendication 3, **caractérisé en ce que**
- le raccord à vis (6) relie la première carte de circuits imprimés (4) au support (7) de manière mécaniquement amovible.

5. Appareil électrique (1) selon la revendication 3 ou 4, **caractérisé en ce que**
- le support (7) est relié de manière électriquement conductrice à la première paroi de boîtier (3) électriquement conductrice.

6. Appareil électrique (1) selon l'une quelconque des revendications 3 à 5, **caractérisé en ce que**
- la première paroi de boîtier (3) et le support (7) sont réalisés d'un seul tenant.

7. Appareil électrique (1) selon la revendication 6, **caractérisé en ce que**
- la première paroi de boîtier (3) électriquement conductrice et le support (7) sont réalisés sous la forme d'une pièce pliée estampée.

8. Appareil électrique (1) selon la revendication 7, **caractérisé en ce que**
- le support (7) est plié vers l'intérieur du boîtier (2) .

9. Appareil électrique (1) selon la revendication 8, **caractérisé en ce que**
- l'appareil électrique présente une protection anti-pénétration (8) qui ferme une ouverture (9) dans la première paroi de boîtier (3) électriquement conductrice qui est formée par le support (7) plié vers l'intérieur du boîtier (2).

10. Appareil électrique (1) selon l'une quelconque des revendications précédentes, **caractérisé en ce que**
- une vis (10) du raccord à vis (6) présente une étendue longitudinale qui s'étend perpendiculairement à la première carte de circuits imprimés (4).

11. Appareil électrique (1) selon l'une quelconque des revendications précédentes, **caractérisé en ce que**
- l'appareil électrique (1) présente une deuxième carte de circuits imprimés (11) qui s'étend de manière plane et parallèle à la première paroi de boîtier (3) électriquement conductrice, la deuxième carte de circuits imprimés (11) retenant la première carte de circuits imprimés (4).
